# EUROPÄISCHE PATENTSCHRIFT

(11) **EP 0 617 437 B1**
(45) Veröffentlichungstag und Bekanntmachung des Hinweises auf die Patenterteilung: **03.12.1997**
(21) Anmeldenummer: 94102682.5
(22) Anmeldetag: 23.02.1994
(51) Int. Cl.: H01F 21/04

(54) **Verfahren zum Abstimmen eines in SMD-Technik aufgebauten Schwingkreises**
Tuning method for an oscillating circuit in SMD technique
Méthode d'accord pour un circuit oscillateur en technique de montage de surface

(30) Priorität: 25.03.1993 DE 4309715
(43) Veröffentlichungstag der Anmeldung: 28.09.1994
(73) Patentinhaber: GRUNDIG Aktiengesellschaft, 90762 Fürth (DE)
(72) Erfinder: Ritter, Kai-Uwe, GRUNDIG Aktiengesellschaft, D-90762 Fürth (DE)

(56) Entgegenhaltungen:
- DE-A- 3 615 307
- DE-A- 3 938 718
- DE-A- 4 020 305

## Beschreibung

Die Erfindung betrifft ein Verfahren zum Abstimmen eines in SMD-Technik aufgebauten Schwingkreises oder eines elektrischen Filters nach dem Oberbegriff des Anspruchs 1.

Für Hochfrequenzanwendungen werden sehr kleine Induktivitäten hoher Güte benötigt. Die höchsten Güten lassen sich mit sogenannten Luftspulen erzielen. Das sind Spulen, die keinen Kern und keinen Wickelkörper aufweisen und meist aus freitragenden Windungen bestehen. Sollen beispielsweise elektrische Filter aufgebaut werden, so müssen entweder abgleichbare Kapazitäten oder abgleichbare Spulen verwendet werden. Abgleichbare Kapazitäten sind jedoch sehr teuer und beeinflussen die Güte der Gesamtschaltung negativ. Es bietet sich demnach an, für solche Anwendungen in ihrer Induktivität abgleichbare Spulen einzusetzen. Dies ist bekannt und wird in der Hochfrequenztechnik vielfach praktiziert. Dazu werden bei den eingesetzten Luftspulen die Abstände der einzelnen Windungen verändert, um die gewünschte Induktivität der Spulen zu erreichen.

Problematisch wird diese Technik, wenn die Schaltung in SMD-Technik aufgebaut werden soll (SMD steht für Surface Mounted Devices). Hierbei stellen sich zwei Probleme: Werden als Spulen hergestellte SMD-Bauteile verwendet, so sind diese zwar mit SMD-Bestückungsautomaten verarbeitbar, jedoch nach dem Verlöten (z.B. Reflow-Löten) nicht mehr abgleichbar, da sie, um sie verarbeitbar zu machen, bereits im mit Kunststoff ganz oder teilweise vergossenen Zustand vorliegen müssen.

Eine derartige, teilweise vergossene Spule ist beispielsweise aus dem Dokument DE 36 15 307 A1 bekannt.

Verwendet man andererseits aber freitragende Luftspulen, die nach dem Verlöten einwandfrei abstimmbar sind, so sind diese mit SMD-Bestückungsautomaten nicht bestückbar, da sie mit den bei diesen Bestückungsautomaten eingesetzten Saugpipetten nicht aufgenommen werden können. Dies trifft insbesondere bei Schwingkreisen in der Hochfrequenz-Technik (ab einer Frequenz von ca. 1 GHz) zu, weil hier die Spulen oft nur aus zwei Windungen bestehen.

Bezüglich des mechanischen Zustandes der in der Leiterplatte verlöteten Spulen tritt noch ein weiteres Problem auf. Es handelt sich dabei um die sogenannte Mikrofonie. Die Gefahr der Mikrofonie tritt immer dann auf, wenn eine Luftspule die als frequenzbestimmendes Element in einem Oszillator eingesetzt wird, in mechanische Schwingungen versetzt wird. Die Schwingfrequenz des Oszillators schwankt dann mit der Frequenz der mechanischen Schwingung der Luftspule. Dies ist gleichbedeutend mit einer Frequenzmodulation des Oszillators und ist beispielsweise dann bei einem Empfänger hörbar. Als Beispiel können hier die Oszillatoren in Autoradios genannt werden, die durch Motorvibrationen zum Schwingen angeregt werden können. Bei mikrofonieempfindlichen Einsätzen von Luftspulen müssen deren Windungen nach dem Abgleich unbedingt am mechanischen Schwingen gehindert werden. Im allgemeinen geschieht dies durch Verkleben der Windungen mit einem dazu geeigneten Mittel wie Lack, Wachs, Kleber oder dergleichen.

Der Einsatz von Wachs beim Herstellen von mit elektrischen und elektronische Bauteilen bestückten Leiterplatten ist aus US 4269870 bekannt. Dort wird beschrieben, elektrische und elektronische Bauteile lose in Löcher einer Leiterplatte zu stecken und die Bauteile vorübergehend bis zum Löten mit einem Klebstoff zu sichern. Bevorzugt wird dazu ein synthetisches Wachs mit einem Schmelzpunkt zwischen 120 und 195^{o}F (49 und 91^{o}C) eingesetzt. Das vorübergehende Befestigen der Bauteile dient dazu, sie vor dem Löten in ihre endgültige Lage auszurichten und bis zum Löten in dieser Position zu halten. Beim Lötvorgang schmilzt dann das Wachs vollkommen weg.

Darüber hinaus sind Spulen bekannt, die einen Mehrteiligen Spulenkern aufweisen, wobei entweder ein Teil des Spulenkerns selbst oder die Verklebung der Teile aus einem Wachs oder einer anderen, sich verflüchtigenden Substanz besteht.

Aus DE 39 38 718 A1 ist eine Spule bekannt, die einen zweiteiligen Kern aufweist. Die Teile des Spulenkerns sind keilförmig und entlang der schrägen Fläche der Teile miteinander mittels eins Wachses verklebt. Beim Verlöten schmilzt das Wachs und ein Teil des Spulenkerns kann entfernt werden, so daß die Windungen der Spule zugänglich sind.

Aus DE 40 20 305 A1 ist eine Spule bekannt, die einen Spulenkern aufweist, dessen Grundteil aus einem hitzebeständigem Material besteht. Auf das Grundteil ist ein zweites Teil aus einem sich bei Hitze verflüchtigenden Material, wie z. B. Kollophonium, aufgebracht. Beim Verlöten verflüchtigt sich das zweite Teil und die Windungen der Spule sind zugänglich.

Die aus dem Stand der Technik bekannten Spulen weisen jedoch den Nachteil auf, daß mehrteilige Spulenkerne verwendet werden müssen.

Aufgabe der Erfindung ist es, ein Verfahren zu schaffen, das es ermöglicht, zum einen abgleichbare Luftspulen in SMD-Schaltungen einzusetzen und zum anderen diese Luftspulen mit den herkömmlichen SMD-Bestückungsautomaten mit Saugpipetten verarbeiten zu können.

Diese Aufgabe wird durch die im Anspruch 1 aufgeführten kennzeichnenden Merkmale gelöst. Die Unteransprüche geben vorteilhafte Ausführungsformen der Erfindung an.

Es ist bekannt, beispielsweise in elektrische Filter in der SMD-Technik Spulen einzusetzen, die durch Vergießen mit einem Isolierwerkstoff gegen mechanische Beschädigungen von außen geschützt sind und nur zwei freiliegende Kontaktstellen besitzen, mit denen sie auf der Leiterplatte verlötet werden. Eine derartige Spule wird in dem deutschen Gebrauchsmuster G 91 00 042 offenbart. Dort wird die Spule zwar in einem elektrischen Filter eingesetzt, da sie jedoch durch Einwirkung auf die Windungen wegen der Ummantelung nicht abgleichbar ist, wird der Abgleich in einer anderen Art, auf die hier nicht näher eingegangen wird, durchgeführt.

Ebenfalls bekannt ist es, beim Einsatz von Luftspulen in SMD-Leiterplatten, die Luftspulen in Spezial-Wickelautomaten zu wickeln und unmittelbar in die Leiterplatte einzusetzen. Diese Wickelautomaten befinden sich dabei im Bestückungsdurchlauf der Leiterplatten. Eine derartige Möglichkeit ist nur wirtschaftlich, wenn eine entsprechend hohe Leiterplattenstückzahl vorliegt, die einen Einsatz von Spezial-Wickelautomaten rechtfertigt. Sie ist insbesondere nicht zur Lösung der gestellten Aufgabe geeignet, da dort die Verarbeitbarkeit der Spulen mit SMD-Bestückungsautomaten verlangt wird, was das Aufnehmen der Spulen mittels Saugpipetten bedeutet.

Für das erfindungsgemäße Verfahren wird vorgeschlagen, eine Luftspule zu verwenden, die einerseits eine für die Verarbeitbarkeit mit SMD-Bestückungsautomaten notwendige ganze oder teilweise Umhüllung mit einem geeigneten Mittel aufweist und andererseits nach dem Verlöten mit der Leiterplatte durch Änderung der Windungsabstände abgleichbar ist. Der Erfindungsgedanke geht dahin, für die ganze oder teilweise Umhüllung der Luftspule ein Mittel zu verwenden, welches sich während des Lötvorganges ganz oder teilweise verflüchtigt oder abfließt. Das Verflüchtigen oder Abfließen muß dabei in dem Maß erfolgen, daß die Windungen soweit frei werden, daß die für den Abgleich notwendige Abstandsänderung der Windungen durchführbar ist. Ein geeignetes, bei der Löttemperatur von beispielsweise 230 bis 250^{o}C (Reflow-Löten) abfließendes Mittel, wäre Klebewachs. Es sind aber noch andere geeignete Mittel denkbar. Der Vorteil von Klebewachs ist der, daß bei einem für die Löttemperatur richtig eingestellten Schmelzpunkt des Wachses, dieses zwar aus den Spulenwindungen fließt, aber in dem Bereich der Lötseite noch in einer Menge verbleibt, die nach dem Abgleich der Spule die notwendige mechanische Fixierung der Windungen zur Vermeidung von Mikrofonie gewährleistet. Wird ein sich verflüchtigendes Mittel zur Umhüllung verwendet, so ist es vorteilhaft, dieses während des Lötvorganges mit einer geeigneten Einrichtung abzusaugen. Ist das für die Umhüllung verwendete Mittel nach dem Löten ganz verflüchtigt oder abgeflossen, muß, wenn erforderlich, eine nachträgliche Fixierung der Windungen durch beispielsweise Lack, Wachs oder Kleber vorgenommen werden. Das kann von Hand oder durch Einsatz einer automatischen Vorrichtung erfolgen.

## Patentansprüche

1. Verfahren zum Abstimmen eines in SMD-Technik aufgebauten Schwingkreises oder eines elektrischen Filters in der Hochfrequenz-Technik, wobei der Schwingkreis aus einem in seiner Kapazität nicht veränderbaren, oberflächenmontierbaren Kondensator und einer oberflächenmontierbaren, in ihrer Induktivität abgleichbaren Luftspule besteht,
**dadurch gekennzeichnet,** daß
- eine Luftspule verwendet wird, die mit einem sich bei Löttemperatur verflüchtigenden oder erweichenden und ganz oder teilweise abfließenden ersten Tränkmittel ganz oder teilweise umhüllt ist,
- diese Luftspule mit herkömmlichen, in der SMD-Technik gebräuchlichen Einrichtungen, wie beispielsweise Saugpipetten, hantier- und montierbar ist,
- während des Lötvorganges sich das genannte erste Tränkmittel ganz oder teilweise verflüchtigt oder erweicht und ganz oder teilweise abfließt,
- die Induktivität der Luftspule durch Ändern des Windungsabstandes zur Erreichung der gewünschten Frequenz eingestellt wird und
- gegebenenfalls die Windungen nach der Einstellung der Induktivität durch Aufbringen eines zweiten Tränkmittels, zur Vermeidung von Mikrofonie, in ihrer eingestellten Lage fixiert werden.

2. Verfahren nach Anspruch 1,
**dadurch gekennzeichnet,** daß das erste Tränkmittel bei einer Temperatur von > 200°C sich verflüchtigt oder erweicht.

3. Verfahren nach den Ansprüchen 1 und 2,
**dadurch gekennzeichnet,** daß das während des Lötvorganges verflüchtigte, gasförmige erste Tränkmittel abgesaugt wird.

4. Verfahren nach den Ansprüchen 1 und 2,
**dadurch gekennzeichnet,** daß es sich bei dem ersten Tränkmittel beispielsweise um Klebewachs handelt.

5. Verfahren nach den Ansprüchen 1 und 2,
**dadurch gekennzeichnet,** das zweite Tränkmittel aus beispielsweise Lack, Wachs, Kleber oder einem anderen zur Lagefixierung von Drahtwindungen geeigneten Stoff besteht.

6. Verfahren nach einem oder mehreren der Ansprüche 1 bis 5, **dadurch gekennzeichnet,** daß das zweite Tränkmittel von Hand oder automatisch mittels einer entsprechenden Einrichtung auf die abgeglichenen Luftspulen aufgebracht wird.

## Claims

1. Method for tuning an oscillatory circuit constructed in SMD technology or an electrical filter using highfrequency technology, wherein the oscillatory circuit comprises a surface-mountable capacitor whose capacitance cannot be varied and a surface-mountable air coil whose inductance can be aligned, characterized in that
- an air coil is used which is completely or partially enclosed by a first impregnating agent which volatilizes or softens at the soldering temperature and completely or partly drains away,
- said air coil is manipulable and mountable using conventional devices which are standard in SMD technology, such as, for example, suction pipettes,
- during the soldering operation, the said first impregnating agent volatilizes completely or partly or softens and completely or partly drains away,
- the inductance of the air coil is adjusted by changing the turn spacing to achieve the desired frequency, and
- if necessary, fixing the turns in their set position to avoid microphony after adjusting the inductance by applying a second impregnating agent.

2. Method according to Claim 1, characterized in that the first impregnating agent volatilizes or softens at a temperature of > 200°C.

3. Method according to Claims 1 and 2, characterized in that the gaseous, first impregnating agent volatilized during the soldering operation is sucked off.

4. Method according to Claims 1 and 2, characterized in that the first impregnating agent is, for example, an adhesive wax.

5. Method according to Claims 1 and 2, characterized in that the second impregnating agent is composed, for example, of lacquer, wax, adhesive or another substance suitable for fixing the position of wire turns.

6. Method according to one or more of Claims 1 to 5, characterized in that the second impregnating agent is applied to the aligned air coils by hand or automatically by means of a suitable device.

## Revendications

1. Procédé pour accorder un circuit oscillant agencé selon la technique SMD de montage en surface ou d'un filtre électrique dans la technique des hautes fréquences, le circuit oscillant étant constitué par un condensateur, dont la capacité n'est pas modifiable et qui peut être monté en surface, et par une bobine sans fer, qui peut être montée en surface et dont l'inductance peut être équilibrée,
caractérisé en ce
- qu'on utilise une bobine sans fer, qui est enveloppée en totalité ou en partie par un premier milieu d'imprégnation qui se volatilise ou se ramollit à la température de brasage et s'écoule en partie ou en totalité,
- cette bobine sans fer peut être manipulée et montée à l'aide de dispositifs classiques, usuels dans la technique SMD, comme par exemple des pipettes d'aspiration,
- pendant le processus de brasage, le premier moyen d'imprégnation indiqué est volatilisé ou ramolli en totalité ou en partie et s'écoule en totalité ou en partie,
- on modifie l'inductance de la bobine sans fer en modifiant la distance des spires pour obtenir la fréquence désirée, et
- éventuellement on fixe les spires dans leur position réglée après le réglage de l'inductance, par application d'un second milieu d'imprégnation, pour éviter un effet microphonique.

2. Procédé selon la revendication 1, caractérisé en ce que le premier milieu d'imprégnation se volatilise ou se ramollit à une température > 200°C.

3. Procédé selon les revendications 1 et 2, caractérisé en ce que pendant l'opération de brasage, le premier milieu d'imprégnation volatilisé sous forme gazeuse est évacué par aspiration.

4. Procédé selon les revendications 1 et 2, caractérisé en ce qu'en ce qui concerne le premier milieu d'imprégnation, il s'agit par exemple d'une cire adhésive.

5. Procédé selon les revendications 1 et 2, caractérisé en ce que le second milieu d'imprégnation est formé par exemple d'une laque, d'une cire, d'une colle ou d'une autre substance appropriée pour fixer la position des spires de fil.

6. Procédé selon une ou plusieurs des revendications 1 à 5, caractérisé en ce que le second milieu d'imprégnation est appliqué à la main ou de façon automatique à l'aide d'un dispositif correspondant, sur les bobines sans fer équilibrées.
